(19) Europäisches Patentamt
European Patent Office
Office européen des brevets

(11) EP 2 208 810 B1

(12) FASCICULE DE BREVET EUROPEEN

(45) Date de publication et mention
de la délivrance du brevet:
**14.12.2011 Bulletin 2011/50**

(51) Int Cl.:
*C30B 11/04* ^(2006.01)   *C30B 13/10* ^(2006.01)
*C30B 15/04* ^(2006.01)   *C30B 29/06* ^(2006.01)

(21) Numéro de dépôt: **09180793.3**

(22) Date de dépôt: **28.12.2009**

(54) **Procédé de solidification de semi-conducteur avec ajout de charges de semi-conducteur dopé au cours de la cristallisation**

Verfahren zur Erstarrung eines Halbleiters mit Zusatz eines dotierten Halbleiters während der Kristallisation

Method for solidifying a semiconductor with adding charges of a doped semiconductor during the crystallisation

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **05.01.2009 FR 0950016**

(43) Date de publication de la demande:
**21.07.2010 Bulletin 2010/29**

(73) Titulaire: **Commissariat à l'Énergie Atomique et aux Énergies Alternatives**
**75015 Paris (FR)**

(72) Inventeurs:
• **Servant, Florence**
  **38410 VAULNAVEYS LE HAUT (FR)**
• **Camel, Denis**
  **73000, CHAMBERY (FR)**

(74) Mandataire: **Ilgart, Jean-Christophe et al**
**BREVALEX**
**95 rue d'Amsterdam**
**75378 Paris Cedex 8 (FR)**

(56) Documents cités:
**EP-A- 0 330 189**        **WO-A-2007/032799**
**US-A1- 2008 220 544**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

**DOMAINE TECHNIQUE**

L'invention concerne un procédé de solidification de semi-conducteur, notamment de silicium, permettant de contrôler le dopage du semi-conducteur lors de sa solidification. L'invention s'applique particulièrement à la cristallisation de silicium métallurgique par voie liquide sous la forme de lingots ou de rubans utilisés pour la réalisation de substrats de cellules photovoltaïques.

**ÉTAT DE LA TECHNIQUE ANTÉRIEURE**

Lors de la solidification dirigée d'un semi-conducteur contenant un ou plusieurs dopants, la concentration des dopants varie le long de la direction de cristallisation du fait que la composition du solide formé est différente de celle du liquide (accumulation de dopants dans le liquide dans le cas le plus général). Plus précisément, dans le cas où il y a un mélange complet du liquide, la distribution des dopants dans ce lingot, selon la direction de cristallisation, suit la loi de Scheil-Gulliver qui fait intervenir, pour chaque type de dopant, son coefficient de partage $k = S_S/S_L$, avec $S_S$ la solubilité de l'espèce dopante dans le silicium solide et $S_L$ la solubilité de l'espèce dopante dans le silicium liquide (fondu). Le bore et le phosphore ont tous les deux une solubilité dans le silicium solide plus faible que dans le silicium liquide, ce qui se traduit par un coefficient de partage inférieur à 1.

Pour une espèce dopante donnée, la loi de Scheil-Gulliver s'écrit sous la forme suivante :

$$C_S = k.C_{LO}.(1-f_S)^{k-1},$$

avec :

    $C_S$ : Concentration de l'espèce dopante dans le semi-conducteur solide cristallisé,
    $C_{LO}$) : Concentration initiale de l'espèce dopante dans le semi-conducteur liquide,
    $k$ : coefficient de partage de l'espèce dopante,
    $f_S$ : fraction du semi-conducteur cristallisé par rapport à la totalité du semi-conducteur (liquide + solide).

Cette variation de concentration entraine une variation des propriétés électriques telles que la conductivité. De plus, elle conduit à rejeter la partie supérieure du lingot où cette concentration augmente très fortement, ce qui réduit le rendement matière du procédé.

Les cellules photovoltaïques standards actuelles sont généralement réalisées à partir de substrats issus de lingots de silicium métallurgique purifié. Ce type de silicium contient des impuretés, et notamment des espèces dopantes, ou dopants, qui apportent au silicium une certaine conductivité électrique.

Un semi-conducteur est qualifié de « compensé » lorsqu'il contient à la fois des dopants accepteurs d'électrons et des dopants donneurs d'électrons. La concentration en porteurs libres dans un tel semi-conducteur correspond à la différence entre le nombre d'électrons et le nombre de trous apportés par les dopants, qui sont généralement du bore (type p, c'est-à-dire accepteur d'électrons) et du phosphore (type n, c'est-à-dire donneur d'électrons) lorsque le semi-conducteur est du silicium.

Le coefficient de partage du phosphore, $k_P$, est égal à 0,35, et le coefficient de partage du bore, $k_B$, est égal à 0,8.

Lors de la cristallisation d'un lingot de silicium de type p non compensé, ce lingot comporte comme unique espèce dopante du bore. La répartition des atomes de bore dans le lingot est assez homogène sur la majorité de la hauteur du lingot car, étant donné que le coefficient de partage du bore est égal à 0,8, cet élément ségrége peu dans le silicium.

Mais, lors de la réalisation d'un lingot de silicium contenant du phosphore, c'est-à-dire soit du silicium de type n compensé ou non, soit du silicium de type p compensé, étant donné que le phosphore ségrége plus que le bore ($k_P$ = 0,35), la résistivité du lingot obtenu est donc inhomogène le long de la hauteur du lingot de silicium.

De plus, au niveau du début (c'est-à-dire la partie ayant cristallisée en premier) d'un lingot de silicium compensé de type p, la concentration en bore y est plus importante que la concentration en phosphore. Etant donné que le phosphore ségrége mieux que le bore, le silicium sera, à partir d'une certaine hauteur solidifiée, plus riche en phosphore qu'en bore, donnant lieu à un changement de type de conductivité dans le lingot. Une partie du lingot sera donc inutilisable. De plus, cet effet sera accentué (changement de type de conductivité encore plus proche du début du lingot) si la différence entre les concentrations de bore et de phosphore au début du lingot est faible, c'est-à-dire lorsque l'on souhaite obtenir du silicium de résistivité élevée, par exemple pour la réalisation de cellules photovoltaïques (résistivité supérieure à environ 0,1 ohm.cm). Cet effet sera encore plus accentué si le silicium contient beaucoup de phosphore pour une même résistivité.

Bien que ce changement de type de conductivité ne s'observe pas sur les lingots de type n, puisque la concentration de phosphore reste toujours supérieure à la concentration de bore, cet écart entre ces concentrations sera plus élevé en haut du lingot qu'au début du lingot, ce qui se traduit par une résistivité inhomogène, qui diminue le long de la hauteur du lingot.

Ainsi, dans tous les cas, une grande partie du lingot est inutilisable, que ce soit en raison de la résistivité inhomogène, ou en raison d'un changement de type de conductivité.

Le document WO 2007/001184 A1 décrit un procédé de réalisation de lingot de semi-conducteur dans lequel, pour réduire l'inhomogénéité de la résistivité et repousser l'emplacement de changement de conductivité dans le lingot, des dopants de type n ou p sont ajoutés au cours de la croissance cristalline du silicium. Bien que ces ajouts de dopants permettent de mieux réguler l'équilibre entre les espèces dopantes dans le bain de semi-conducteur durant la croissance, comparativement à une croissance sans ajout qui suit la loi de Scheil-Gulliver, le nombre total d'espèces dopantes devient beaucoup plus élevé que sans ajout, ce qui affecte les propriétés électriques des dispositifs réalisés à partir du silicium cristallisé obtenu, en particulier la mobilité.

Le document US 2008/220544 A1 décrit un procédé de solidification de semi-conducteur, comportant les étapes de :

- former un bain de semi-conducteur fondu à partir d'une première charge de semi-conducteur comportant des dopants,
- solidifier le semi-conducteur fondu,

et comportant en outre, au cours de la solidification du semi-conducteur fondu, la mise en oeuvre, au cours d'une partie du procédé de solidification, d'une ou plusieurs étapes d'ajout d'une ou plusieurs charges supplémentaires du semi-conducteur, compostant également des dopants, au bain de semi-conducteur fondu.

## EXPOSÉ DE L'INVENTION

Un but de la présente invention est de proposer un procédé permettant de solidifier, par exemple une cristallisation sous la forme de lingots, un semi-conducteur selon le type de conductivité souhaité, et ayant une résistivité homogène le long du semi-conducteur solidifié tout en évitant les changements de type de conductivité sur la totalité ou une très grande partie du semi-conducteur, et qui ne dégrade pas les propriétés électriques des dispositifs réalisés à partir du semi-conducteur obtenu.

Un but de la présente invention est également de proposer un procédé amélioré de cristallisation dirigée de semi-conducteurs dopés dans lequel la variation de la densité de porteurs libres le long de la direction de cristallisation est, sur tout ou partie du lingot, plus faible que dans les procédés conventionnels sans ajout en cours de cristallisation, tout en assurant une variation de la densité totale de porteurs libres plus faible que lorsque la variation de la densité de porteurs libres est corrigée par un ajout de dopant purs.

Pour cela, la présente invention propose un procédé de solidification de semi-conducteur, comportant au moins les étapes de :

- former un bain de semi-conducteur fondu à partir d'au moins une première charge de semi-conducteur comportant des dopants,
- solidifier le semi-conducteur fondu,

et comportant en outre, au cours de la solidification du semi-conducteur fondu, la mise en oeuvre, au cours d'au moins une partie du procédé de solidification, d'une ou plusieurs étapes d'ajout d'une ou plusieurs charges supplémentaires du semi-conducteur, comportant également des dopants, au bain de semi-conducteur fondu, abaissant la variabilité de la valeur du terme $\sum_{i=1}^{n} k_i C_L^i - \sum_{j=1}^{m} k_j C_L^j$ du semi-conducteur fondu du bain par rapport à la variabilité réalisée naturellement par les valeurs des coefficients de partage des espèces dopantes telle que :

$$(\sum_{i=1}^{n} k_i C_a^i - \sum_{j=1}^{m} k_j C_a^j) < (\sum_{i=1}^{n} k_i C_L^i - \sum_{j=1}^{m} k_j C_L^j) \quad \text{si} \quad \sum_{i=1}^{n} k_i(1-k_i)C_L^i > \sum_{j=1}^{m} k_j(1-k_j)C_L^j$$

$$(\sum_{i=1}^{n} k_i C_a^i - \sum_{j=1}^{m} k_j C_a^j) > (\sum_{i=1}^{n} k_i C_L^i - \sum_{j=1}^{m} k_j C_L^j) \quad \text{si} \quad \sum_{i=1}^{n} k_i(1-k_i)C_L^i < \sum_{j=1}^{m} k_j(1-k_j)C_L^j$$

et abaissant la variabilité de la valeur du terme $\sum_{i=1}^{n} k_i C_L^i + \sum_{j=1}^{m} k_j C_L^j$ du semi-conducteur fondu du bain par rapport à la variabilité réalisée par des ajouts d'espèces dopantes pures telle que :

$$\sum_{i=1}^{n} k_i C_a^i < \sum_{i=1}^{n} k_i C_L^i \qquad \text{et} \qquad \sum_{j=1}^{m} k_j C_a^j < 2\sum_{i=1}^{n+m} k_i C_L^i \qquad \text{si}$$

$$\sum_{i=1}^{n} k_i(1-k_i)C_L^i > \sum_{j=1}^{m} k_j(1-k_j)C_L^j \quad ;$$

$$\sum_{j=1}^{m} k_j C_a^j < \sum_{j=1}^{m} k_j C_L^j \qquad \text{et} \qquad \sum_{i=1}^{n} k_i C_a^i < 2\sum_{i=1}^{n+m} k_i C_L^i \qquad \text{si}$$

$$\sum_{i=1}^{n} k_i(1-k_i)C_L^i < \sum_{j=1}^{m} k_j(1-k_j)C_L^j \quad ;$$

avec $C_L^i$ : concentration en dopants i accepteurs d'électrons dans le bain de semi-conducteur fondu ;
$C_L^j$ : concentration en dopants j donneurs d'électrons dans le bain de semi-conducteur fondu ;
$C_a^1$ : concentration en dopants i accepteurs d'électrons dans la ou les charges supplémentaires ajoutées ;
$c_a^j$ : concentration en dopants j donneurs d'électrons dans la ou les charges supplémentaires ajoutées ;
$k_i$ : coefficient de partage des dopants i accepteurs d'électrons ;
$k_j$ : coefficient de partage des dopants j donneurs d'électrons.

Ainsi, selon la composition relative entre les dopants dans le bain (riche en dopants i accepteurs d'électrons dans le cas où $\sum_{i=1}^{n} k_i(1-k_i)C_L^i > \sum_{j=1}^{m} k_j(1-k_j)C_L^j$, ou riche en dopants j donneurs d'électrons dans le cas où $\sum_{i=1}^{n} k_i(1-k_i)C_L^i < \sum_{j=1}^{m} k_j(1-k_j)C_L^j$), la dilution aura un effet sur la baisse de la variabilité de la densité de porteurs libres si la composition de la charge ajoutée en espèce dopante i, $C_a^i$, est telle que le premier solide formé à partir de celle-ci aurait une densité de porteurs inférieure au solide formé par le bain sans les ajouts dans le cas riche en dopants accepteurs d'électrons, ou supérieure au solide formé par le bain sans les ajouts dans le cas riche en dopants donneurs d'électrons, c'est-à-dire :

$$(\sum_{i=1}^{n} k_i C_a^i - \sum_{j=1}^{m} k_j C_a^j) < (\sum_{i=1}^{n} k_i C_L^i - \sum_{j=1}^{m} k_j C_L^j) \text{ dans le cas riche en dopants i accepteurs d'électrons, ou}$$

$$(\sum_{i=1}^{n} k_i C_a^i - \sum_{j=1}^{m} k_j C_a^j) > (\sum_{i=1}^{n} k_i C_L^i - \sum_{j=1}^{m} k_j C_L^j) \text{ dans le cas riche en dopants j donneurs d'électrons.}$$

La dilution aura aussi un effet sur le nombre total de porteur libres : $\sum_{i=1}^{n} k_i C_a^i < \sum_{i=1}^{n} k_i C_L^i$ dans le cas d'un bain riche en dopants i accepteurs d'électrons m m et $\sum_{j=1}^{m} k_j C_a^j < \sum_{j=1}^{m} k_j C_L^j$ dans le cas d'un bain riche en dopants j donneurs d'électrons.

De plus, en imposant les conditions $\sum_{j=1}^{m} k_j C_a^j < 2\sum_{i=1}^{n+m} k_i C_L^i$ lorsque $\sum_{i=1}^{n} k_i (1-k_i) C_L^i > \sum_{j=1}^{m} k_j (1-k_j) C_L^j$, lorsque

$\sum_{i=1}^{n} k_i (1-k_i) C_L^i < \sum_{j=1}^{m} k_j (1-k_j) C_L^j$, on borne ainsi la concentration des dopants de façon a ce qu'il y ait toujours un phénomène de dilution. Etant donné que la vitesse de solidification est directement liée aux concentrations d'ajout, celle-ci se retrouve donc également bornée.

Ainsi, on sélectionne tout d'abord au moins deux sous-charges de compositions moyennes différentes en termes de concentrations de dopants. On forme ensuite un bain de semi-conducteur en faisant fondre une première des sous-charges, par exemple dans un creuset. On commence alors la solidification de cette première sous-charge puis, au cours de la solidification, la seconde sous-charge est alors ajoutée, préférentiellement de façon continue tout au long de la cristallisation, au bain de semi-conducteur, apportant ainsi des dopants dans le bain de semi-conducteur, mais réalisant également une dilution de ces dopants étant donné que l'on augmente la quantité de silicium fondu dans le bain.

L'ajout de silicium dopé et non de dopants purs permet de ne pas affecter la mobilité des porteurs majoritaires car contrairement à l'art antérieur, on n'augmente pas ou peu les concentrations des dopants dans le bain de semi-conducteur fondu.

Ce procédé permet de compenser l'ajout de dopants dans le bain lors de la solidification (due à la ségrégation) par l'ajout d'une quantité de semi-conducteur non négligeable. En effet, cet ajout de semi-conducteur permet de faire baisser les concentrations des dopants par dilution de semi-conducteur dans le bain, et donc de garder le nombre total de porteurs majoritaires dans le bain de semi-conducteur, correspondant au terme $\sum_{i=1}^{n} k_i C_L^i + \sum_{j=1}^{m} k_j C_L^j$, à un niveau sensiblement constant, ne dégradant pas les propriétés électriques des dispositifs, par exemple des cellules photovoltaïques, réalisés à partir du semi-conducteur solidifié obtenu. Par exemple, le dopage de la charge ajoutée en quantité non négligeable peut comporter moins de dopants donneurs d'électrons que la charge initiale pour un taux de dopants accepteurs d'électrons donné, et ce quelque soit le type de conductivité de la charge. Ainsi, on ajoute juste ce qu'il faut de dopants accepteurs d'électrons grâce à cette dilution. De plus, ce procédé permet d'utiliser des charges recyclées pour réaliser cette solidification.

Il est ainsi possible d'obtenir du silicium solidifié non compensé de type p présentant une variabilité de sa résistivité et du nombre de porteurs libres inférieure à environ 10% sur environ plus de 90 % de sa hauteur. Il est aussi possible d'obtenir du silicium solidifié compensé de type p avec un rapport du nombre de dopants accepteurs d'électrons sur le nombre de dopants donneurs d'électrons compris entre 0,6 et 3, présentant un variabilité de résistivité inférieure à 20% et une variabilité du nombre total de porteurs inférieure à environ 50% sur environ plus de 70 % de sa hauteur.

Ce procédé permet donc également d'augmenter le rendement matière de la solidification car seule une très faible partie du semi-conducteur solidifié est écroutée étant donné qu'une très grande partie du semi-conducteur solidifié présente les propriétés électriques souhaitées.

Plus généralement, disposant de charges de silicium hétérogènes en termes de dopage, l'invention permet de solidifier des lingots de semi-conducteur de résistivité constante sur une grande partie de sa hauteur, malgré le phénomène de ségrégation des dopants (quelque soit le dopant, même autre que le bore ou le phosphore).

L'invention s'applique à tout type de procédé de solidification de semi-conducteur, et notamment tout type de procédé de cristallisation par voie liquide.

Le procédé exposé ci-dessus est décrit de manière générale lorsqu'un ou plusieurs dopants i donneurs d'électrons et un ou plusieurs dopants j accepteurs d'électrons sont utilisés. Dans le cas où seul le bore est utilisé en tant que dopant i accepteur d'électrons et que seul le phosphore est utilisé en tant que dopant j donneur d'électrons, les indices n et m sont alors égaux à 1, et les paramètres d'indice i correspondent alors aux paramètres du bore ($k_B$, $C_L^B$, $C_a^B$) et les paramètres d'indice j correspondent alors aux paramètres du phosphore ($k_P$, $C_L^P$, $C_a^P$).

La ou les charges supplémentaires de semi-conducteur peuvent être ajoutées en respectant les relations suivantes :

$$C_a^P = C_a^B \frac{(1-k_P)C_L^P}{(1-k_B)C_L^B} + C_L^P * \frac{(k_P - k_B)}{(1-k_B)},$$

et

$$\frac{dm_a}{dm_S} = \frac{C_L^B(1-k_B)}{(C_L^B - C_a^B)} > 1 - k_P \, ,$$

avec :

dm$_a$ /dt : vitesse d'ajout en kg/s,

dm$_S$ /dt : vitesse de cristallisation en kg/s

Ainsi, en respectant ces relations, la ou les charges supplémentaires de semi-conducteur sont ajoutées à une vitesse d'ajout conservant les valeurs des termes K$_B$C$_L$$^B$ et k$_P$C$_L$$^P$ sensiblement constants au cours d'au moins une partie du procédé de solidification.

La ou les charges supplémentaires de semi-conducteur peuvent être apportées avec une vitesse d'ajout telle

que : $\dfrac{dm_a}{dm_S} < 1$ , c'est-à-dire avec une vitesse d'ajout inférieure à la vitesse de cristallisation, ce qui correspond à des concentrations de dopants ajoutés telles que :

$$C_a^P < k_P C_L^P \quad \text{et} \quad C_a^B < k_B C_L^B \; .$$

Une telle vitesse d'ajout permet notamment d'assurer la fin des ajouts avant la fin de la cristallisation.

La ou les charges supplémentaires du semi-conducteur peuvent être ajoutées au bain de semi-conducteur sous forme solide, puis peuvent être fondues et mélangées au bain de semi-conducteur fondu.

La ou les charges supplémentaires du semi-conducteur peut être ajoutées au bain de semi-conducteur sous forme liquide au cours d'au moins une partie du procédé de solidification. Dans un mode de réalisation préférentiel, cet ajout sous forme liquide est réalisé de manière continue.

Lorsque plusieurs charges supplémentaires du semi-conducteur sont ajoutées au cours de la solidification, une charge supplémentaire de semi-conducteur peut être ajoutée à chaque fois que la masse du semi-conducteur solidifié augmente d'au plus 1 % par rapport à la masse totale de semi-conducteur solidifié obtenue à la fin du procédé de solidification.

Les étapes du procédé de solidification peuvent être mises en oeuvre dans un four de type Bridgman, le bain de semi-conducteur pouvant être disposé dans un creuset dudit four.

Le four peut comporter une enceinte fermée et sous atmosphère d'argon dans laquelle est disposé le creuset.

Lorsque la ou les charges supplémentaires de semi-conducteur sont ajoutées au bain de semi-conducteur sous forme solide, ce ou ces ajouts peuvent être réalisés par un dispositif de distribution pouvant réaliser également un préchauffage de la ou des charges supplémentaires de semi-conducteur.

Dans ce cas, les instants auxquels sont réalisés le ou les ajouts de la ou des charges supplémentaires de semi-conducteur peuvent être déterminés par des moyens de commande du dispositif de distribution.

La concentration d'au moins un type de dopants dans la première charge de semi-conducteur peut être différente de la concentration de ce même type de dopants dans la ou les charges supplémentaires de semi-conducteur.

La concentration en dopants d'un type de conductivité dans la première charge de semi-conducteur peut être supérieure ou égale à la concentration en dopants de ce même type de conductivité dans la ou les charges supplémentaires de semi-conducteur.

Le semi-conducteur fondu peut être solidifié sous la forme d'un lingot ou d'un ruban.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

-    la figure 1 représente un four de type Bridgman dans lequel un procédé de solidification de semi-conducteur, objet de la présente invention, est mis en oeuvre,
-    les figures 2 à 4 représentent des courbes de simulation de concentrations en dopants et de résistivités le long de lingots de silicium solidifiés selon un procédé objet de la présente invention et de lingots de silicium solidifiés selon un procédé de l'art antérieur.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

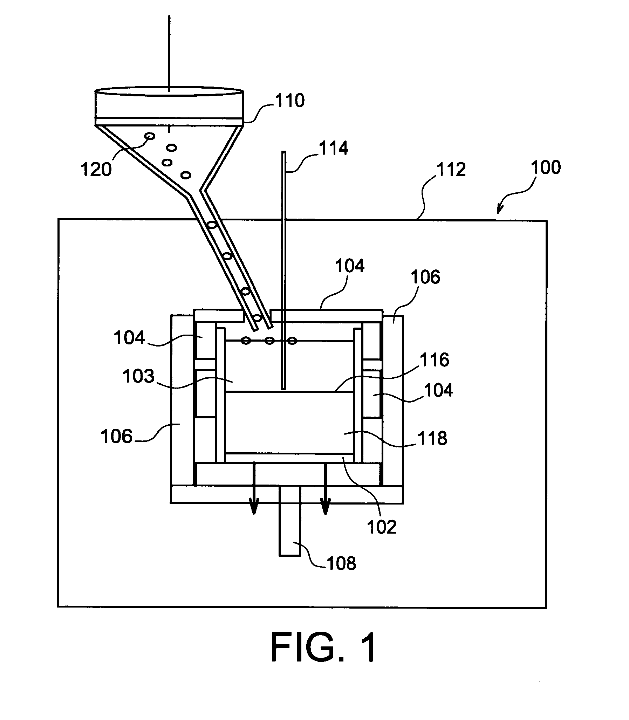

On se réfère tout d'abord à la figure 1 qui représente un four 100 de type Bridgman, ou four à fusion de zones, dans lequel un procédé de solidification, ici de cristallisation, de semi-conducteur est mis en oeuvre.

Le four 100 comporte un creuset 102 destiné à recevoir du semi-conducteur fondu 103 à cristalliser. Sur la figure 1, du semi-conducteur cristallisé 118 est également disposé dans le creuset 102, sous le bain de semi-conducteur 103. Le four 100 comporte également des éléments chauffants 104, par exemple alimentés électriquement, disposés au-dessus du creuset 102 et contre une partie supérieure des parois latérales du creuset 102. Ces éléments chauffants 104 permettent de faire fondre le semi-conducteur lorsqu'il est introduit sous forme solide dans le creuset 102, et de le maintenir sous forme fondu. Le four 100 comporte également des parois latérales 106 thermiquement isolantes.

Le four 100 comporte un système de refroidissement 108 disposé sous le creuset 102, permettant de réaliser la cristallisation du semi-conducteur en canalisant le flux de chaleur vers le bas (parallèlement à l'axe de croissance du semi-conducteur), et favoriser ainsi la croissance de grains colonnaires dans le semi-conducteur. Ainsi, le semi-conducteur fondu 103 se trouvant dans le creuset 102 se cristallise au fur et à mesure en partant du fond du creuset 102. Le four 100 comporte également une enceinte fermée 112 permettant au semi-conducteur à cristalliser de se trouver dans une atmosphère de gaz inerte, par exemple de l'argon.

Le four 100 comporte en outre un dispositif de distribution 110 disposé au-dessus du creuset 102. Ce dispositif de distribution 110 permet d'ajouter des charges supplémentaires de semi-conducteur 120 dans le creuset 102, au cours du processus de cristallisation du semi-conducteur. Les charges supplémentaires 120 sont ici ajoutées sous forme solide et ont par exemple des dimensions inférieures à environ 10 cm, et préférentiellement inférieures à environ 1 cm, afin que ces charges supplémentaires puissent rapidement fondre dans le bain de semi-conducteur 103. Le dispositif de distribution 110 est préférentiellement rempli au fur et à mesure du procédé de cristallisation grâce à un sas étanche possédant son propre système de pompage et d'injection d'argon. De plus, ce dispositif de distribution 110 permet également de réaliser un préchauffage du semi-conducteur destiné à être ajouté dans le creuset 102 au cours du procédé de solidification.

Dans une variante, le semi-conducteur supplémentaire ajouté au cours du procédé de cristallisation peut l'être sous forme liquide, ce semi-conducteur supplémentaire étant dans ce cas fondu hors du bain de semi-conducteur, puis ajouté sous la forme d'une coulée continue ou discontinue au bain de semi-conducteur.

Enfin, le four 100 comporte une canne de palpage 114, par exemple en silice, installée au dessus du creuset 102 et permettant connaître la position du front de solidification 116 du semi-conducteur, c'est-à-dire la frontière entre le semi-conducteur fondu 103 et le semi-conducteur cristallisé 118 en fonction du temps de cristallisation.

On décrit maintenant le procédé de cristallisation du semi-conducteur qui est mis en oeuvre dans le four 100.

Une première charge de semi-conducteur, par exemple du silicium, comportant des dopants, est disposée dans le creuset 102. On fait alors fondre cette première charge de silicium grâce aux éléments chauffants 104, formant un bain de silicium fondu 103. Dans une variante, il est également possible de couler directement du silicium fondu dans le creuset 102. On commence alors le processus de cristallisation du semi-conducteur fondu. Au bout d'un certain temps de cristallisation, une petite quantité de silicium préchauffée est ajoutée grâce au dispositif de distribution 110 placé au dessus du bain de silicium fondu. Ce silicium qui arrive dans le bain de silicium fondu sous forme solide flotte alors à la surface du bain de silicium 103 puisque sa densité est plus faible que le silicium fondu. Cette charge supplémentaire de silicium va alors fondre et être mélangée au bain de silicium 103 pour être ensuite cristallisé. L'ajout de silicium va alors être renouvelé à une certaine fréquence afin de garder une concentration en dopants sensiblement constante dans le lingot cristallisé.

En choisissant de manière adéquate les concentrations en dopants et les masses des charges de silicium utilisées, ainsi que les moments auxquels les charges supplémentaires sont ajoutées, on peut ainsi conserver les valeurs des termes $K_B C_L^B - K_P C_L^P$ et $K_B C_L^B + k_P C_L^P$ dans le bain de semi-conducteur fondu sensiblement constantes tout au long, ou au cours d'une grande partie, du procédé de cristallisation. $C_L^B$ et $C_L^P$ correspondent respectivement aux concentrations en dopants accepteurs et donneurs d'électrons dans le semi-conducteur fondu se trouvant dans le creuset 102. $k_B$ et $k_P$ correspondent respectivement aux coefficients de partage de ces dopants accepteurs et donneurs d'électrons.

L'apport de charges supplémentaires de semi-conducteur peut être réalisé en une ou plusieurs fois au cours du procédé de cristallisation. Les différentes charges ajoutées peuvent notamment avoir des masses et/ou des concentrations en dopants différentes, avec par exemple un flux de matière (quantité de semi-conducteur ajouté) au plus égal au flux de production de la matière cristallisée.

Les différentes charges de semi-conducteur qui sont utilisées dans ce procédé de cristallisation sont choisies en fonction de leurs concentrations en espèces dopantes, de leurs coefficients de partage respectifs, et des propriétés finales souhaitées pour le semi-conducteur cristallisé (homogénéité de composition et propriétés électriques). L'homogénéité est optimisée par le choix de l'instant auquel est débuté l'apport complémentaire de semi-conducteur, et de la vitesse à laquelle cet apport est fait, cet apport pouvant être continu ou discontinu.

Tous ces paramètres sont choisis en fonction de la résistivité et de la concentration en dopants souhaitées dans le lingot de semi-conducteur cristallisé. On décrit ci-dessous les calculs réalisés permettant de choisir le type de charges de semi-conducteur à utiliser pour réaliser ce procédé de cristallisation

On choisit tout d'abord la résistivité $\rho_0$ du lingot que l'on souhaite obtenir dont la valeur dépend du nombre de porteurs libres na-nd. On a la relation :

$$\rho_0 = \frac{1}{|na-nd| \times q \times \mu(T)} \qquad (1)$$

avec q : charge d'un électron

$\mu$ : mobilité des porteurs majoritaires

na-nd : nombre de porteurs majoritaires

La mobilité $\mu$, dont la valeur dépend de la densité totale des porteurs majoritaires na+nd, est définie par la relation empirique suivante :

$$\mu(T) = \mu_{min} T_n^{\beta 1} + \frac{(\mu_{max} - \mu_{min}) T_n^{\beta 2}}{1 + \left(\dfrac{na + nd}{N_{ref} T_n^{\beta 3}}\right)^{\alpha T_n^{\beta 4}}} \qquad (2)$$

avec Tn : la température normalisée à 300 K. Les constantes utilisées dans cette relation dépendent de la nature des porteurs (électron pour le type n ou trou pour le type p) et sont égales aux valeurs présentées dans le tableau suivant :

| | | Porteurs Majoritaires | | | Température | | | |
|---|---|---|---|---|---|---|---|---|
| | $\mu_{max}$ | $\mu_{min}$ | $N_{ref}$(cm-3) | $\alpha$ | $\beta$1 | $\beta$2 | $\beta$3 | $\beta$4 |
| Electrons | 1417 | 60 | 9,64*10E16 | 0,664 | -0,57 | -2,2 | 2,4 | -0,146 |
| Trous | 470 | 37,4 | 2,82*10E16 | 0,642 | | | | |

Les termes na et nd représentent le nombre de dopants respectivement accepteurs et donneurs d'électrons d'atomes, et sont assimilés respectivement au nombre d'atomes de bore et de phosphore, dans le silicium cristallisé. Pour un volume unitaire, on peut considérer que les concentrations en dopants dans le silicium cristallisé correspondent à na et nd :

$$na = C_S^B = k_B C_L^B(t) \quad et \quad nd = C_S^P = k_P C_L^P(t),$$

exprimés en ppma.

Etant donné que les coefficients de partage du bore et du phosphore sont différents ($k_B$ = 0,8 et $k_P$ = 0,35), la valeur du terme na-nd n'est donc pas constante lors d'un procédé de cristallisation ne comportant pas d'étapes d'ajout de charges supplémentaires de semi-conducteur au cours de la cristallisation. Cela se traduit lors d'un tel procédé par un enrichissement en phosphore du silicium liquide, cet enrichissement se répercutant ensuite dans le silicium cristallisé. Cet enrichissement est décrit par la loi de Scheil-Gulliver selon la relation :

$$C_S^{i(g)} \;=\; k_{\text{B}} C_{LO}^{i} \,(1-f_S)^{k_i-1} \qquad\qquad (3)$$

avec i : l'espèce dopante (i = B ou P),
$f_S$ : la fraction solidifiée de semi-conducteur, et
$C_{LO}^{i}$ : la concentration initiale du liquide pour l'espèce i.

En réalisant des ajouts de charges supplémentaires de semi-conducteur comportant des dopants au cours de la cristallisation, on réalise une compensation de l'enrichissement en phosphore précédemment décrit, grâce par exemple à l'ajout de silicium moins dopé en phosphore (ou plus dopé en bore) afin de garder la valeur du terme na-nd ou $k_B C_L^{B}$ - $K_P C_L^{P}$ plus faible que sans ajout et la valeur du terme na+nd ou $K_B C_L^{B}$ + $K_P C_L^{P}$ plus faible qu'avec des ajouts de dopants purs, dans le bain de semi-conducteur pendant la cristallisation.
En fonction des caractéristiques de la première charge utilisée ou du bain liquide à l'instant de l'ajout :

- masse ($M_I$ ou $M_L$),
- concentrations en dopants ($C_I^{B}$, $C_I^{P}$) ou ($C_L^{B}$, $C_L^{P}$),

et des caractéristiques souhaitées pour le semi-conducteur cristallisé :

- résistivité de départ po,
- fluctuations de na-nd à l'instant t dû à un ajout de charge discontinu,
- dérive de na-nd entre deux hauteurs du lingot,

on choisit des charges supplémentaires ($C_a^{B}$, $C_a^{P}$) adaptées, variables ou constantes, à ajouter au cours du procédé et une vitesse d'ajout par rapport à la vitesse de cristallisation ($dm_a/dm_s$) variable ou constante.
Pour connaître la vitesse d'ajout et la concentration de la charge ajoutée à l'instant t, on écrit un bilan de soluté dans la partie liquide de silicium. Ce bilan de soluté s'écrit pour les deux dopants i = B, P comme :

$$d(C_L^{i} m_L) \;=\; C_a^{i} dm_a \;-\; k_i C_L^{i} dm_S \qquad\qquad (4)$$

- $dm_a$ : masse ajoutée pendant le temps dt,
- $C_a^{1}$ : concentration de la charge ajouté en espèce i,
- $dm_s$ : masse solidifiée pendant le temps dt Les concentrations sont exprimées ici en ppma (parties par million en atomique).

Ce bilan signifie que la variation du nombre d'atomes de dopants i dans le liquide est égale au nombre d'atomes de dopants i apportés par l'ajout moins le nombre d'atomes de dopants i cristallisés dans l'intervalle de temps dt.
Le terme $m_L(t)$ peut s'exprimer en fonction des autres masses de semi-conducteur mises en jeu par l'équation :

$$m_L(t) \;=\; M_1 \;+\; m_a(t) \;-\; m_S(t) \qquad\qquad (5)$$

avec $M_1$ : la masse de la première charge (constante),
$m_a(t)$ : la masse totale de silicium ajouté à l'instant t (avec en fin d'ajout $t_f$ : $m_a(t_f) = M_2$)
$m_S(t)$ : la masse totale de silicium cristallisée à l'instant t (avec en fin d'ajout $t_f$ : $m_s(t_f) = M_1 + M_2$)

A partir des équations (4) et (5) exprimées ci-dessus, il est possible d'écrire la variation dans le liquide $dC_L^{i}(t)$ en fonction de $dm_S(t)$ et $dm_a(t)$ :

$$m_L(t) * dC_L^{i}(t) = C_L^{i}(t) * (1 - k_i) * dm_S(t) + (C_a^{i} - C_L^{i}) * dm_a(t) \qquad (6)$$

Pour donner une valeur de la variation de $k_B C_L^{B}$ - $K_P C_L^{P}$ pour deux dopants, on obtient :

$$m_L(t)*d(k_B C_L^B - k_P C_L^P) = \left(k_B(1-k_B)C_L^B - k_P(1-k_P)C_L^P\right)dm_S - \left(k_B(C_L^B - C_a^B) - k_P(C_L^P - C_a^P)\right)*dm_a$$
(7)

Le premier terme représente la variation de $k_B C_L^B - k_P C_L^P$ apporté par la loi de Scheil pour une certaine masse liquide $m_L$ correspondant au cas sans ajouts. Le deuxième terme représente la variation de $k_B C_L^B - k_P C_L^P$ apportée par les ajouts de silicium dopés. Pour voir une amélioration par rapport au cas sans ajout, ce deuxième terme doit être positif si on a un bain riche en bore $\left(k_B(1-k_B)C_L^B - k_P(1-k_P)C_L^P\right) > 0$ ou négatif si le bain est riche en phosphore $\left(k_B(1-k_B)C_L^B - k_P(1-k_P)C_L^P\right) < 0$.

La vitesse d'ajout optimale qui en découle vaut :

$$dm_a(t) = \frac{C_L^B(t)k_B(1-k_B) - C_L^P(t)k_P(1-k_P)}{(k_B(C_L^B - C_a^B) - k_P(C_L^P - C_a^P))} * dm_S$$

dans le cas où $k_B C_L^B - k_P C_L^P$ reste constant.

Le même bilan (6) permet d'établir la variation de la valeur du terme $k_B C_L^B + k_P C_L^P$ et de la comparer avec une même variation de $k_B C_L^B - K_P C_L^P$ dans le cas d'ajout avec dopants purs et on déduit que :

$C_a^P < C_L^P$ dans le cas d'un bain riche en phosphore et que $C_a^B < C_L^B$ dans le cas d'un bain riche en Bore.

Dans le cas où l'on garde constant $K_B C_L^B$ et $K_P C_L^P$ tout le long de la cristallisation, ces termes sont toujours égaux à $k_B C_1^B$ et $k_P C_1^P$. L'équation (6) s'écrit alors pour chaque espèce i :

$$\frac{dm_a(t)}{dm_S(t)} = \frac{C_1^i(t)*(1-k_i)}{(C_1^i - C_a^i)}$$

avec une vitesse d'ajout par rapport à vitesse de cristallisation constante et inférieure à 1 pour finir les ajouts avant la cristallisation.

La concentration de la charge ajoutée doit donc satisfaire la relation :

$$C_a^P = C_a^B \frac{(1-k_P)C_1^P}{(1-k_B)C_1^B} + C_1^P * \frac{(k_P - k_B)}{(1-k_B)}$$

avec une vitesse d'ajout de :

$$\frac{dm_a}{dm_S} = \frac{C_L^B(1-k_B)}{(C_L^B - C_a^B)} > 1 - k_P$$

Dans ce cas la masse des charges totales ajoutées est de :

$$\frac{M_2}{M_1 + M_2} = \frac{C_L^B(1-k_B)}{(C_L^B - C_a^B)}$$

préférentiellement réparties en charges de très petites quantités.

On décrit maintenant un premier exemple de réalisation d'un lingot de silicium non compensé de type p, c'est-à-dire ne comportant comme espèce dopante que du bore, et de résistivité souhaitée égale à environ 3,32 ohm.cm.

La charge fondue initialement est du silicium microélectronique dopé uniquement en bore avec une concentration de 0,04 ppmw (soit $5,2^E15$ atomes/cm$^3$). La masse de la première charge est égale à la moitié de la masse finale du lingot. Les charges supplémentaires qui sont ajoutées au bain de silicium au cours du procédé de cristallisation sont à base de silicium de même origine électronique, également dopées uniquement en bore, mais ayant une concentration de 0,004 ppmw. La masse totale de ces charges supplémentaires représente la moitié de la masse finale du lingot.

Les ajouts des charges supplémentaires se font à chaque fois que la masse du semi-conducteur cristallisé augmente d'environ 0,2 % par rapport à la masse totale cristallisée de semi-conducteur obtenue à la fin du procédé de cristallisation. Ces ajouts commencent dès le début de la cristallisation.

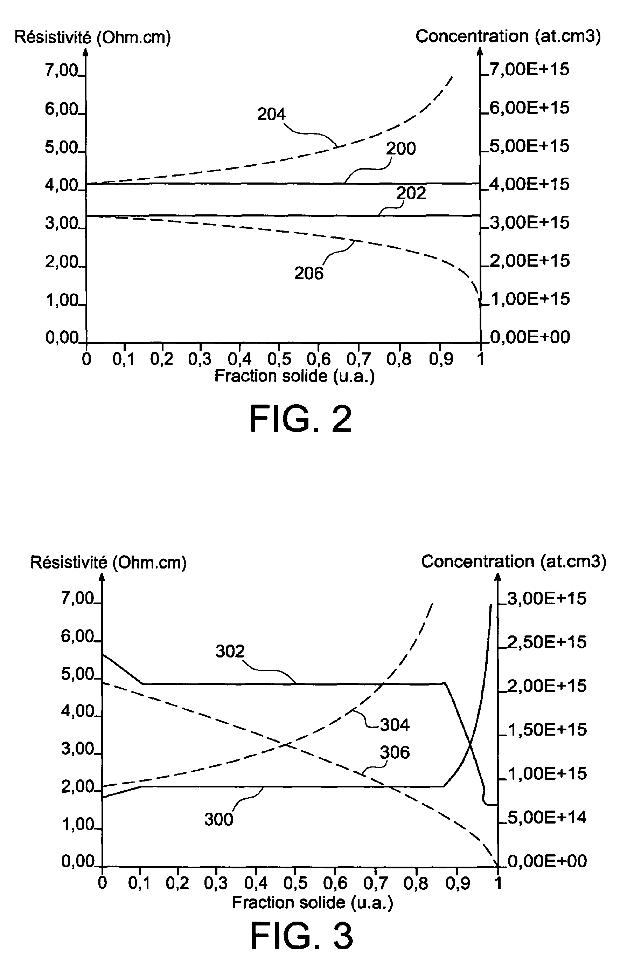

La courbe 200 de la figure 2 représente la concentration en bore dans le silicium cristallisé (axe verticale de droite) en fonction de la hauteur du lingot (axe horizontal, avec une échelle normalisée). Ainsi, on voit que le lingot obtenu présente une concentration en bore constante et égale à environ $4,2^E15$ atomes/cm$^3$ sur toute la hauteur du lingot. De manière analogue, la courbe 202 de la figure 2 représente la résistivité du silicium cristallisé (axe verticale de gauche) en fonction de la hauteur du lingot. On voit sur cette courbe 202 que le lingot obtenu présente une résistivité constante et égale à environ 3,32 ohm.cm sur toute la hauteur du lingot.

Par comparaison, la courbe 204 représente la concentration en bore dans un lingot de silicium obtenu par cristallisation d'une charge fondue de nature similaire à celle de la charge initiale précédemment décrite, mais sans réaliser d'ajout de charges supplémentaires au cours de la cristallisation du silicium, en fonction de la hauteur du lingot. Sur cette courbe 204, on voit que la concentration en bore augmente au fur et à mesure de la cristallisation car le bore ségrège pendant la cristallisation en suivant la loi de Scheil-Gulliver. La courbe 206 représente la résistivité du silicium cristallisé en fonction de la hauteur de ce lingot. On voit sur cette courbe que la résistivité de ce lingot chute vers zéro lorsque la cristallisation se termine, vers le sommet du lingot.

Le lingot obtenu en réalisant régulièrement des ajouts de charges supplémentaires durant la cristallisation du silicium peut donc être utilisé sur toute sa longueur pour réaliser des substrats, par exemple destinés à la réalisation de cellules photovoltaïques. Par contre, si l'on souhaite réaliser des substrats de résistivité comprise entre environ 3,32 ohm.cm et 2,6 ohm.cm , soit une variation de 20 % par rapport à la valeur optimale de 3,32 ohm.cm, à partir du lingot réalisé sans les ajouts de charges supplémentaires, seulement 68 % du lingot pourra être utilisé. Si une variation de 10 % sur la valeur de la résistivité est tolérée, seulement 43 % de ce lingot pourra être utilisé. Enfin, si une variation de 5 % sur le valeur de la résistivité est tolérée, seulement 24 % du lingot pourra être utilisé pour la réalisation des ces wafers, tandis que la totalité du lingot cristallisé avec des ajouts de charges peut être utilisée.

On décrit maintenant un second exemple de réalisation d'un lingot de silicium non compensé de type n, c'est-à-dire ne contenant comme espèce dopante que du phosphore, et de résistivité souhaitée égale à environ 4,89 ohm.cm.

La charge fondue initialement est du silicium microélectronique dopé uniquement en phosphore avec une concentration de 0,05 ppmw (soit $2,2^E E15$ atomes/cm$^3$). La masse de la première charge est égale à environ la moitié de la masse finale du lingot. Les charges supplémentaires qui sont ajoutées au bain de silicium au cours du procédé de cristallisation sont à base de silicium de même origine électronique, également dopé uniquement en phosphore, mais ayant une concentration égale à 0,005 ppmw. La masse totale de ces charges supplémentaires représentent la moitié de la masse finale du lingot.

Les ajouts des charges supplémentaires se font à chaque fois que la masse du semi-conducteur cristallisé augmente d'environ 0,2 % par rapport à la masse totale cristallisée de semi-conducteur obtenue à la fin du procédé de cristallisation. Dans cet exemple, ces ajouts commencent lorsqu'environ 10 % du lingot est déjà cristallisé.

La courbe 300 de la figure 3 représente la concentration en bore dans le silicium cristallisé (axe verticale de droite) en fonction de la hauteur du lingot (axe horizontal, avec une échelle normalisée). Ainsi, on voit que le silicium cristallisé obtenu présente une concentration en bore qui augmente au niveau des premiers 10 % du lingot, c'est-à-dire lorsqu'aucun ajout de charges supplémentaires n'est réalisé, puis devient constante jusqu'à environ 85 % de la hauteur du lingot lorsque les ajouts des charges supplémentaires sont réalisés. De manière analogue, la courbe 302 de la figure 3 représente la résistivité du silicium cristallisé (axe verticale de gauche) en fonction de la hauteur du lingot. On voit sur cette courbe 302 que le silicium cristallisé obtenu présente une résistivité qui baisse sur les premiers 10 % du lingot, puis devient constante et égale à environ 4,89 ohm.cm jusqu'à environ 85 % de la hauteur du lingot.

Par comparaison, la courbe 304 représente la concentration en phosphore dans un lingot de silicium obtenu par cristallisation d'une charge fondue de silicium microélectronique dopé en phosphore avec une concentration de 0,0578 ppmw, mais sans réaliser d'ajout de charges supplémentaires au cours de la cristallisation du lingot, en fonction de la hauteur du lingot. Sur cette courbe 304, on voit que la concentration en phosphore dans le silicium cristallisé chute tout au long du lingot car le phosphore ségrège pendant la cristallisation en suivant la loi de Scheil-Gulliver. La courbe 306 représente la résistivité du silicium en fonction de la hauteur de ce lingot. On voit sur cette courbe que la résistivité de ce lingot chute vers zéro tout au long de la cristallisation.

Si l'on souhaite réaliser des substrats de résistivité variant au plus de 20 % par rapport à la valeur optimale de 4,89 ohm.cm, à partir du lingot obtenu avec des ajouts de charges supplémentaires, 91 % du lingot pourra être utilisé. Comparativement, seulement 30 % du lingot réalisé sans les ajouts de charges supplémentaires pourra dans ce cas être utilisé. Si une variation de 10 % sur la valeur de la résistivité est tolérée, alors seulement 85 % du lingot réalisé avec les ajouts pourra être utilisé, contre environ 15 % du lingot réalisé sans les ajouts. Enfin, si une variation de 5 % sur la valeur de la résistivité est tolérée, 81 % du lingot obtenu avec ajouts pourra être utilisé, tandis que seulement 8 % du lingot réalisé sans les ajouts pourra être utilisé.

Dans l'exemple précédemment décrit, les ajouts de charges supplémentaires sont réalisés de préférence lorsqu'environ 10 % de la hauteur totale du lingot est déjà cristallisé car ces premiers 10 % du lingot sont généralement écroutés. Dans une variante, il est également possible que les ajouts de charges supplémentaires soient réalisés dès le début de la cristallisation, mais arrêtés lorsqu'environ 90 % de la hauteur totale du lingot est cristallisé.

On décrit maintenant un troisième exemple de réalisation d'un lingot de silicium compensé de type p, c'est-à-dire comportant à la fois du bore et du phosphore avec un taux de bore fixe égal à environ 2 ppmw, et de résistivité souhaitée égale à environ 0,63 ohm.cm.

La charge fondue initialement est du silicium d'origine métallurgique purifié dopé en bore avec une concentration de 2 ppmw et en phosphore avec une concentration de 9,5 ppmw. Cette première charge pèse environ la moitié de la masse finale du lingot. Les charges supplémentaires qui sont ajoutées au bain de silicium au cours du procédé de cristallisation sont à base de silicium de même origine métallurgique, également dopé en bore avec une concentration de 2 ppmw, mais ayant une concentration en phosphore de 2 ppmw. La masse totale de ces charges supplémentaires représente la moitié de la masse finale du lingot.

Les ajouts des charges supplémentaires se font à chaque fois que la masse du semi-conducteur cristallisé augmente d'environ 0,2 % par rapport à la masse totale solidifiée de semi-conducteur obtenue à la fin du procédé de solidification. Dans cet exemple, ces ajouts commencent lorsqu'environ 10 % du lingot est déjà cristallisé.

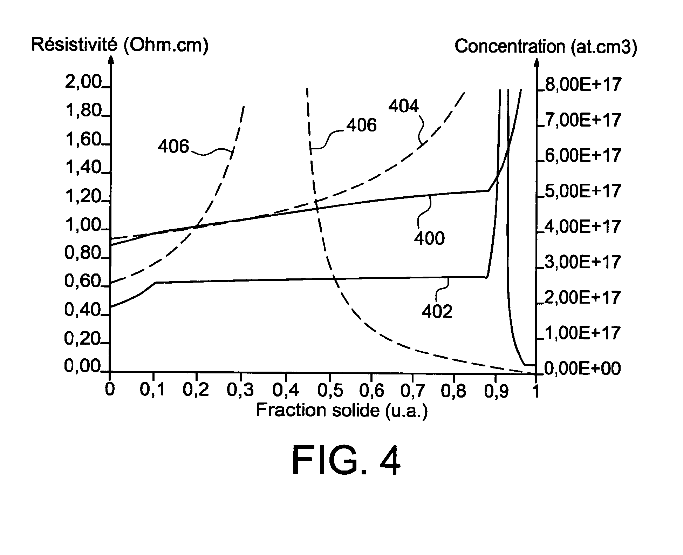

La courbe 400 de la figure 4 représente la concentration totale des porteurs majoritaires na + nd dans le silicium cristallisé (axe verticale de droite) en fonction de la hauteur du lingot (axe horizontal, avec une échelle normalisée). Ainsi, on voit que cette concentration obtenue augmente relativement faiblement en raison des ajouts des charges supplémentaires qui réalisent une dilution de ces charges dans le bain, jusqu'à environ 85 % de la hauteur du lingot. De manière analogue, la courbe 402 de la figure 4 représente la résistivité du silicium cristallisé (axe verticale de gauche) en fonction de la hauteur du lingot. On voit sur cette courbe 402 que le lingot obtenu présente une résistivité qui augmente sur les premiers 10 % du lingot, puis devient relativement constante autour de la valeur de 0,63 ohm.cm grâce aux ajouts des charges supplémentaires, jusqu'à environ 85 % de la hauteur du lingot. Une divergence de type de conductivité a lieu de façon abrupte à environ 92 % de la hauteur totale du lingot de silicium en raison des différences des coefficients de partage du phosphore et du bore, le phosphore ségrégant mieux que le bore. Les derniers 8 % du lingot sont donc de type n.

Par comparaison, la courbe 404 représente la concentration totale des porteurs majoritaires na + nd dans un lingot de silicium obtenu par cristallisation d'une charge fondue de silicium de nature métallurgique purifié dopé en bore avec une concentration de 2 ppmw et en phosphore avec une concentration de 10,42 ppmw, mais sans réaliser d'ajout de charges supplémentaires au cours de la cristallisation du silicium, en fonction de la hauteur du lingot. Sur cette courbe 404, on voit que la concentration na + nd augmente tout au long de la cristallisation car le phosphore et le bore ségrégent pendant la cristallisation en suivant la loi de Scheil-Gulliver. La courbe 406 représente la résistivité du silicium cristallisé en fonction de la hauteur de ce lingot. On voit sur cette courbe que la résistivité de ce silicium varie beaucoup et tend vers l'infini vers 39,5 % de la hauteur du lingot pour ensuite diverger et changer de type de conductivité (type n).

Si l'on souhaite réaliser des substrats de résistivité variant au plus de 20 % par rapport à la valeur optimale de 0,63 ohm.cm, à partir du lingot réalisé avec des ajouts de charges supplémentaires, environ 85 % du lingot pourra être utilisé. Comparativement, seulement 9 % du lingot réalisé sans les ajouts de charges supplémentaires pourra dans ce cas être utilisé. Si une variation de 10 % sur la valeur de la résistivité est tolérée, alors environ 81 % du lingot réalisé avec les ajouts pourra être utilisé, contre environ 5 % du lingot réalisé sans les ajouts. Enfin, si une variation de 5 % sur la valeur de la résistivité est tolérée, environ 44 % du lingot réalisé avec ajouts de charges supplémentaires pourra être utilisé, tandis que seulement 3 % du lingot réalisé sans les ajouts pourra être utilisé.

On décrit maintenant un quatrième exemple de réalisation d'un lingot de silicium compensé de type p, c'est-à-dire comportant à la fois du bore et du phosphore avec un taux de bore fixe égal à environ 1 ppmw, et de résistivité souhaitée égale à environ 0,62 ohm.cm.

La charge fondue initialement est du silicium d'origine métallurgique purifié dopé en bore avec une concentration égale à environ 1 ppmw (soit $1,3^{E}17$ atomes/cm$^3$) et en phosphore avec une concentration égale à environ 4 ppmw (soit $1,82^{E}17$ atomes/cm$^3$). Elle pèse environ la moitié de la masse finale du lingot. Les charges supplémentaires qui sont ajoutées au bain de silicium au cours du procédé de cristallisation sont à base de silicium de même origine métallurgique, également dopé en bore avec une concentration égale à environ 1 ppmw, mais ayant une concentration en phosphore égale à environ 2 ppmw. La masse totale de ces charges supplémentaires représente environ la moitié de la masse finale du lingot.

**EP 2 208 810 B1**

Les ajouts des charges supplémentaires se font à chaque fois que la masse du semi-conducteur cristallisé augmente d'environ 0,2 % par rapport à la masse totale de semi-conducteur cristallisé obtenue à la fin du procédé de cristallisation. Dans cet exemple, ces ajouts commencent lorsqu'environ 10 % du lingot est déjà cristallisé.

Dans ce cas, le changement de type de conductivité a lieu à environ 86 % de la hauteur totale du lingot. Comparativement, en réalisant un lingot sans ajouts de charges supplémentaires durant la cristallisation à partir d'une charge de silicium métallurgique purifié dopé en bore avec une concentration égale à environ 1 ppmw et en phosphore avec une concentration égale à environ 4,35 ppmw, on observe alors un changement de type de conductivité à environ 59,5 % de la hauteur du lingot.

Si l'on souhaite réaliser des substrats de résistivité variant au plus de 20 % par rapport à la valeur optimale de 0,62 ohm.cm, à partir du lingot réalisé avec des ajouts de charges supplémentaires, environ 73 % du lingot pourra être utilisé. Comparativement, seulement 18 % du lingot réalisé sans les ajouts de charges supplémentaires pourra dans ce cas être utilisé. Si une variation de 10 % sur la valeur de la résistivité est tolérée, alors environ 68 % du lingot réalisé avec les ajouts pourra être utilisé, contre environ 11 % du lingot réalisé sans les ajouts. Enfin, si une variation de 5 % sur la valeur de la résistivité est tolérée, environ 64 % du lingot réalisé avec ajouts pourra être utilisé, tandis que seulement 6 % du lingot réalisé sans les ajouts pourra être utilisé.

Dans les troisième et quatrième exemples ci-dessus, on remarque que plus la charge de départ contient du bore, plus la concentration de phosphore nécessaire pour garder la même résistivité augmente. Ce procédé est donc d'autant plus intéressant qu'on dispose de charges riches en bore (et donc riches en phosphore pour une même résistivité). Par exemple, avec une charge initiale de concentration en bore égale à environ 4 ppmw et une résistivité comparable de 0,63 ohm.cm, cette première charge aura alors une concentration égale à environ 22,8 ppmw en phosphore. Dans ce cas, la transition en type n se fera vers 27 % du lingot. L'ajout des charges supplémentaires avec 4 ppmw de bore et 4 ppmw de phosphore permettra de passer de type n de façon bien plus abrupte à 91 % du lingot, sachant que la valeur de résistivité avant la transition à 90 % du lingot est de 0,67 ohm. cm.

**Revendications**

1. Procédé de solidification de semi-conducteur, comportant au moins les étapes de :

- former un bain de semi-conducteur fondu (103) à partir d'au moins une première charge de semi-conducteur comportant des dopants,
- solidifier le semi-conducteur fondu (103), et comportant en outre, au cours de la solidification du semi-conducteur fondu (103), la mise en oeuvre, au cours d'au moins une partie du procédé de solidification, d'une ou plusieurs étapes d'ajout d'une ou plusieurs charges supplémentaires (120) du semi-conducteur, comportant également des dopants, au bain de semi-conducteur fondu (103), abaissant la variabilité de la valeur du terme

$\sum_{i=1}^{n} k_i C_L^i - \sum_{j=1}^{m} k_j C_L^j$ du semi-conducteur fondu du bain (103) par rapport à la variabilité réalisée naturellement par les valeurs des coefficients de partage des espèces dopantes telle que :

$$(\sum_{i=1}^{n} k_i C_a^i - \sum_{j=1}^{m} k_j C_a^j) < (\sum_{i=1}^{n} k_i C_L^i - \sum_{j=1}^{m} k_j C_L^j) \quad \text{si} \quad \sum_{i=1}^{n} k_i(1-k_i)C_L^i > \sum_{j=1}^{m} k_j(1-k_j)C_L^j$$

$$(\sum_{i=1}^{n} k_i C_a^i - \sum_{j=1}^{m} k_j C_a^j) > (\sum_{i=1}^{n} k_i C_L^i - \sum_{j=1}^{m} k_j C_L^j) \quad \text{si} \quad \sum_{i=1}^{n} k_i(1-k_i)C_L^i < \sum_{j=1}^{m} k_j(1-k_j)C_L^j$$

et abaissant la variabilité de la valeur du terme $\sum_{i=1}^{n} k_i C_L^i + \sum_{j=1}^{m} k_j C_L^j$ du semi-conducteur fondu du bain (103) par rapport à la variabilité réalisée par des ajouts d'espèces dopantes pures telle que :

**13**

$$\sum_{i=1}^{n} k_i C_a^i < \sum_{i=1}^{n} k_i C_L^i \qquad \text{et} \qquad \sum_{j=1}^{m} k_j C_a^j < 2\sum_{i=1}^{n+m} k_i C_L^i \qquad \text{si}$$

$$\sum_{i=1}^{n} k_i (1 - k_i) C_L^i > \sum_{j=1}^{m} k_j (1 - k_j) C_L^j \quad ;$$

$$\sum_{j=1}^{m} k_j C_a^j < \sum_{j=1}^{m} k_j C_L^j \qquad \text{et} \qquad \sum_{i=1}^{n} k_i C_a^i < 2\sum_{i=1}^{n+m} k_i C_L^i \qquad \text{si}$$

$$\sum_{i=1}^{n} k_i (1 - k_i) C_L^i < \sum_{j=1}^{m} k_j (1 - k_j) C_L^j \quad ;$$

avec $C_L^i$ : concentration en dopants i accepteurs d'électrons dans le bain de semi-conducteur fondu (103) ;
$C_L^j$ concentration en dopants j donneurs d'électrons dans le bain de semi-conducteur fondu (103);
$C_a^i$ : concentration en dopants i accepteurs d'électrons dans la ou les charges supplémentaires (120) ajoutées ;
$C_a^j$ : concentration en dopants j donneurs d'électrons dans la ou les charges supplémentaires (120) ajoutées ;
$k_i$ : coefficient de partage des dopants i accepteurs d'électrons ;
$k_j$ : coefficient de partage des dopants j donneurs d'électrons.

2. Procédé de solidification de semi-conducteur selon la revendication 1, dans lequel les dopants i accepteurs d'électrons sont des atomes de bore et les dopants j donneurs d'électrons sont des atomes de phosphore.

3. Procédé de solidification de semi-conducteur selon la revendication 2, dans lequel la ou les charges supplémentaires (120) de semi-conducteur sont ajoutées en respectant les relations suivantes :

$$C_a^P = C_a^B \frac{(1 - k_P) C_L^P}{(1 - k_B) C_L^B} + C_L^P * \frac{(k_P - k_B)}{(1 - k_B)} ,$$

et

$$\frac{dm_a}{dm_S} = \frac{C_L^B (1 - k_B)}{(C_L^B - C_a^B)} > 1 - k_P ,$$

avec :

$dm_a$ / dt : vitesse d'ajout en kg/s,
$dm_S$ /dt : vitesse de cristallisation en kg/s

4. Procédé de solidification de semi-conducteur selon la revendication 3, dans lequel la ou les charges supplémentaires (120) de semi-conducteur sont apportées avec une vitesse d'ajout inférieure à la vitesse de cristallisation, vérifiant :

$$C_a^P < k_P C_L^P \quad \text{et} \quad C_a^B < k_B C_L^B$$

5. Procédé de solidification de semi-conducteur selon l'une des revendications précédentes, dans lequel la ou des charges supplémentaires (120) du semi-conducteur sont ajoutées au bain de semi-conducteur (103) sous forme solide, puis sont fondues et mélangées au bain de semi-conducteur fondu (103).

**6.** Procédé de solidification de semi-conducteur selon l'une des revendications 1 à 4, dans lequel la ou les charges supplémentaires (120) du semi-conducteur sont ajoutées au bain de semi-conducteur (103) sous forme liquide au cours d'au moins une partie du procédé de solidification.

**7.** Procédé de solidification de semi-conducteur selon l'une des revendications précédentes, dans lequel, lorsque plusieurs charges supplémentaires (120) du semi-conducteur sont ajoutées au cours de la solidification, une charge supplémentaire (120) de semi-conducteur est ajoutée à chaque fois que la masse du semi-conducteur solidifié (118) augmente d'au plus 1 % par rapport à la masse totale de semi-conducteur solidifié obtenue à la fin du procédé de solidification.

**8.** Procédé de solidification de semi-conducteur selon l'une des revendications précédentes, les étapes dudit procédé de solidification étant mises en oeuvre dans un four (100) de type Bridgman, le bain de semi-conducteur (103) étant disposé dans un creuset (102) dudit four (100).

**9.** Procédé de solidification de semi-conducteur selon la revendication 8, dans lequel le four (100) comporte une enceinte fermée (112) et sous atmosphère d'argon dans laquelle est disposé le creuset (102).

**10.** Procédé de solidification de semi-conducteur selon l'une des revendications précédentes, dans lequel, lorsque la ou les charges supplémentaires de semi-conducteur (120) sont ajoutées au bain de semi-conducteur (103) sous forme solide, ce ou ces ajouts sont réalisés par un dispositif de distribution (110) réalisant également un préchauffage de la ou des charges supplémentaires de semi-conducteur (120).

**11.** Procédé de solidification de semi-conducteur selon la revendication 7, dans lequel les instants auxquels sont réalisés le ou les ajouts de la ou des charges supplémentaires de semi-conducteur (120) sont déterminées par des moyens de commande du dispositif de distribution (110).

**12.** Procédé de solidification de semi-conducteur selon l'une des revendications précédentes, dans lequel la concentration d'au moins un type de dopants dans la première charge de semi-conducteur est différente de la concentration de ce même type de dopants dans la ou les charges supplémentaires de semi-conducteur (120).

**13.** Procédé de solidification de semi-conducteur selon l'une des revendications précédentes, dans lequel le semi-conducteur fondu est solidifié sous la forme d'un lingot ou d'un ruban.

**Claims**

**1.** Method for semiconductor solidification which includes at least steps for:

- forming a bath of molten semiconductor (103) from at least one first charge of semiconductor which includes dopants,
- solidification of the molten semiconductor (103), and which in addition includes, during the course of solidification of the molten semiconductor (103), the implementation, during at least part of the solidification method, of one or more steps for the addition of one or more supplementary charges (120) of the semiconductor, also containing dopants, to the molten semiconductor bath (103), which lowers the variability of the value of the $\sum_{i=1}^{n} k_i C_L^i - \sum_{j=1}^{m} k_j C_L^j$ term of the molten semiconductor in the bath (103) relative to the variability naturally achieved by the values of the partition coefficients for the dopant species such that:

$$\left(\sum_{i=1}^{n} k_i C_a^i - \sum_{j=1}^{m} k_j C_a^j\right) < \left(\sum_{i=1}^{n} k_i C_L^i - \sum_{j=1}^{m} k_j C_L^j\right) \quad \text{if} \quad \sum_{i=1}^{n} k_i(1-k_i)C_L^i > \sum_{j=1}^{m} k_j(1-k_j)C_L^j$$

$$\left(\sum_{i=1}^{n} k_i C_a^i - \sum_{j=1}^{m} k_j C_a^j\right) > \left(\sum_{i=1}^{n} k_i C_L^i - \sum_{j=1}^{m} k_j C_L^j\right) \quad \text{if} \quad \sum_{i=1}^{n} k_i(1-k_i)C_L^i < \sum_{j=1}^{m} k_j(1-k_j)C_L^j$$

and which lowers the variability of the value of the $\sum_{i=1}^{n} k_i C_L^i + \sum_{j=1}^{m} k_j C_L^j$ term of the molten semiconductor in the bath (103) relative to the variability achieved by the addition of pure dopant species such that:

$$\sum_{i=1}^{n} k_i C_a^i < \sum_{i=1}^{n} k_i C_L^i \qquad \text{and} \qquad \sum_{j=1}^{m} k_j C_a^j < 2\sum_{i=1}^{n} k_i C_L^i \qquad \text{if}$$

$$\sum_{i=1}^{n} k_i(1-k_i)C_L^i > \sum_{j=1}^{m} k_j(1-k_j)C_L^j \quad ;$$

$$\sum_{j=1}^{m} k_j C_a^j < \sum_{j=1}^{m} k_j C_L^j \qquad \text{and} \qquad \sum_{i=1}^{n} k_i C_a^i < 2\sum_{i=1}^{n} k_i C_L^i \qquad \text{if}$$

$$\sum_{i=1}^{n} k_i(1-k_i)C_L^i < \sum_{j=1}^{m} k_j(1-k_j)C_L^j \quad ;$$

where $C_L^i$: concentration of electron acceptor dopants i in the molten semiconductor bath (103);
$C_L^j$: concentration of electron donor dopants j in the molten semiconductor bath (103);
$C_a^i$: concentration of electron acceptor dopants i in the supplementary added charge or charges (120);
$c_a^j$: concentration of electron donor dopants j in the supplementary added charge or charges (120);
$k_i$: partition coefficient of the electron acceptor dopants i,
$k_j$: partition coefficient of the electron donor dopants j,

2. Semiconductor solidification method aooording to claim 1, in which electron acceptor dopants i are atoms of boron and electron donor dopants j are atoms of phosphorous.

3. Semiconductor solidification method according to claim 2, in which the supplementary semiconductor charge or charges (120) are added whilst ensuring that the following relationships hold:

$$C_a^P = C_a^B \frac{(1-k_P)C_L^P}{(1-k_B)C_L^B} + C_L^P * \frac{(k_P - k_B)}{(1-k_B)} \; , \quad \text{and}$$

and

$$\frac{dm_a}{dm_S} = \frac{C_L^B(1-k_B)}{(C_L^B - C_a^B)} > 1 - k_P \; ,$$

where:

$dm_a$ / dt: addition speed in kg/s
$dm_S$ / dt: crystallisation speed in kg/s

4. Semiconductor solidification method according to claim 3, in which the supplementary semiconductor charge or charges (120) are added at an addition speed which is less than the speed of crystallisation, which verifies:

$$C_a^P < k_P C_L^P \quad \text{and} \quad C_a^B < k_B C_L^B$$

5. Semiconductor solidification method according to one of the previous claims, in which the supplementary semiconductor charge or charges (120) are added to the semiconductor bath (103) in solid form, and are then fused and mixed with the molten semiconductor bath (103).

6. Semiconductor solidification method according to one of claims 1 to 4, in which the supplementary semiconductor charge or charges (120) are added to the semiconductor bath (103) in liquid form during at least part of the solidification method.

7. Semiconductor solidification method according to one of the previous claims in which, when several supplementary semiconductor charges (120) are added during solidification, a supplementary semiconductor charge (120) is added each time that the mass of solidified semiconductor (118) increases by at most 1% in relation to the total mass of solidified semiconductor obtained at the end of the solidification method.

8. Semiconductor solidification method according to one of the previous claims, where the steps in said solidification method are carried out in a Bridgman type furnace (100), where the semiconductor bath is located in a crucible (102) of said furnace (100).

9. Semiconductor solidification method according to claim 8, in which the furnace (100) includes a closed enclosure (112) which is under an argon atmosphere in which the crucible (102) is placed.

10. Semiconductor solidification method according to one of the previous claims, in which, when the supplementary semiconductor charge or charges (120) are added to the semiconductor bath (103) in solid form, this addition or these additions are carried out using a distribution device (110) which also carries out pre-heating of the supplementary semiconductor charge or charges (120).

11. Semiconductor solidification method according to claim 7 in which the moments in time at which the addition or additions of the supplementary semiconductor charge or charges (120) are made are determined by the means of control of the distribution device (110).

12. Semiconductor solidification method according to one of the previous claims, in which the concentration of at least one type of dopant in the first semiconductor charge is different from the concentration of this same type of dopant in the supplementary semiconductor charge or charges (120).

13. Semiconductor solidification method according to one of the previous claims in which the molten semiconductor is solidified in the form of an ingot or a ribbon.

**Patentansprüche**

1. Verfahren zur Erstarrung eines Halbleiters, welches zumindest die folgenden Schritte umfasst:

- Erzeugen eines Bades eines geschmolzenen Halbleiters (103) ausgehend von mindestens einer ersten Charge eines Halbleiters, die Dotierstoffe enthält,
- Erstarren des geschmolzenen Halbleiters (103), und weiter umfasst, dass, im Verlauf der Erstarrung des geschmolzenen Halbleiters (103), im Verlauf mindestens eines Teils des Erstarrungsverfahrens ein oder mehrere Schritte eines Zusetzens von einer oder mehreren zusätzlichen Chargen (120) des Halbleiters, die ebenfalls Dotierstoffe enthalten, zum Bad des geschmolzenen Halbleiters (103) durchgeführt werden, wodurch die Variabilität des Wertes des Terms $\sum_{i=1}^{n} k_i C_L^i - \sum_{j=1}^{m} k_j C_L^j$ des geschmolzenen Halbleiters des Bades (103) bezogen auf die Variabilität gesenkt wird, die naturgemäß durch die Werte der Verteilungskoeffizienten der dotierenden Stoffe erzielt wird, derart, dass:

$$\left(\sum_{i=1}^{n} k_i C_a^i - \sum_{j=1}^{m} k_j C_a^j\right) < \left(\sum_{i=1}^{n} k_i C_L^i - \sum_{j=1}^{m} k_j C_L^j\right) \text{ falls } \sum_{i=1}^{n} k_i(1-k_i)C_L^i > \sum_{j=1}^{m} k_j(1-k_j)C_L^j$$

$$\left(\sum_{i=1}^{n} k_i C_a^i - \sum_{j=1}^{m} k_j C_a^j\right) > \left(\sum_{i=1}^{n} k_i C_L^i - \sum_{j=1}^{m} k_j C_L^j\right) \text{ falls } \sum_{i=1}^{n} k_i(1-k_i)C_L^i < \sum_{j=1}^{m} k_j(1-k_j)C_L^j$$

und die Variabilität des Wertes des Terms $\displaystyle\sum_{i=1}^{n} k_i C_L^i + \sum_{j=1}^{m} k_j C_L^j$ des geschmolzenen Halbleiters des Bades (103) bezogen auf die Variabilität gesenkt wird, die durch Zusetzen von reinen dotierenden Stoffen erzielt wird, derart dass:

$$\sum_{i=1}^{n} k_i C_a^i < \sum_{i=1}^{n} k_i C_L^i \qquad \text{und} \qquad \sum_{j=1}^{m} k_j C_a^j < 2\sum_{i=1}^{n+m} k_i C_L^i$$

falls

$$\sum_{i=1}^{n} k_i(1-k_i)C_L^i > \sum_{j=1}^{m} k_j(1-k_j)C_L^j \;;$$

$$\sum_{j=1}^{m} k_j C_a^j < \sum_{j=1}^{m} k_j C_L^j \qquad \text{und} \qquad \sum_{i=1}^{n} k_i C_a^i < 2\sum_{i=1}^{n+m} k_i C_L^i$$

falls

$$\sum_{i=1}^{n} k_i(1-k_i)C_L^i < \sum_{j=1}^{m} k_j(1-k_j)C_L^j \;;$$

mit $C_L^i$: Konzentration von Elektronenakzeptor-Dotierstoffen i im Bad des geschmolzenen Halbleiters (103);
$C_L^j$: Konzentration an Elektronendonator-Dotierstoffen j im Bad eines geschmolzenen Halbleiters (103);
$C_a^i$: Konzentration an Elektronenakzeptor-Dotierstoffen i in der oder den zusätzlichen hinzugefügten Chargen (120);
$C_a^j$: Konzentration an Elektronendonator-Dotierstoffen j in der oder den zusätzlichen hinzugefügten Chargen (120);
$k_i$: Verteilungskoeffizient der Elektronenakzeptor-Dotierstoffe i;
$k_j$: Verteilungskoeffizient der Elektronendonator-Dotierstoffe j.

**2.** Verfahren zur Erstarrung eines Halbleiters nach Anspruch 1, bei dem die Elektronenakzeptor-Dotierstoffe i Bor-Atome sind und die Elektronendonator-Dotierstoffe j Phosphor-Atome sind.

**3.** Verfahren zur Erstarrung eines Halbleiters nach Anspruch 2, bei dem die eine oder mehreren zusätzlichen Chargen (120) eines Halbleiters unter Beachtung der folgenden Relationen zugesetzt werden:

$$C_a^P = C_a^B \frac{(1-k_P)C_L^P}{(1-k_B)C_L^B} + C_L^P * \frac{(k_P - k_B)}{(1-k_B)} \ ,$$

und

$$\frac{dm_a}{dm_s} = \frac{C_L^B(1-k_B)}{(C_L^B - C_a^B)} > 1 - k_P \ ,$$

mit:

dm$_a$/dt : Hinzufügegeschwindigkeit in kg/s
dm$_s$/dt : Kristallisationsgeschwindigkeit in kg/s

**4.** Verfahren zur Erstarrung eines Halbleiters nach Anspruch 3, bei dem die eine oder mehreren zusätzlichen Chargen (120) eines Halbleiter mit einer Hinzufügegeschwindigkeit eingebracht werden, die geringer als die Kristallisationsgeschwindigkeit ist, wobei zu verfüllen ist:

$$C_a^P < k_P C_L^P \quad \text{und} \quad C_a^B < k_B C_L^B$$

**5.** Verfahren zur Erstarrung eines Halbleiters nach einem der vorhergehenden Ansprüche, bei dem die eine oder mehreren zusätzlichen Chargen (120) des Halbleiters dem Halbleiterbad (103) in fester Form zugesetzt werden, und dann geschmolzen und mit dem Bad des geschmolzenen Halbleiters (103) vermischt werden.

**6.** Verfahren zur Erstarrung eines Halbleiters nach einem der Ansprüche 1 bis 4, bei dem die eine oder mehreren zusätzlichen Chargen (120) des Halbleiters dem Halbleiterbad (103) in flüssiger Form während zumindest eines Teils des Erstarrungsverfahrens zugesetzt werden.

**7.** Verfahren zur Erstarrung eines Halbleiters nach einem der vorhergehenden Ansprüche, bei dem, während mehrere zusätzliche Charge (120) des Halbleiters im Verlauf der Erstarrung zugesetzt werden, eine zusätzliche Charge (120) eines Halbleiters zugesetzt wird, jedesmal wenn die Masse des verfestigten Halbleiters (118) um höchstens 1 % zunimmt, bezogen auf die Gesamtmasse eines verfestigten Halbleiters, die am Ende des Erstanungsverfahrens erzielt wird.

**8.** Verfahren zur Erstarrung eines Halbleiters nach einem der vorhergehenden Ansprüche, wobei die Schritte des Erstarrungsverfahrens in einem Ofen (100) vom Bridgman-Typ durchgeführt werden, wobei das Halbleiterbad (103) in einem Tiegel (102) des Ofens (100) angeordnet ist.

**9.** Verfahren zur Erstarrung eines Halbleiters nach Anspruch 8, bei dem der Ofen (100) eine geschlossene und unter Argon-Atmosphäre stehende Umhüllung (112) aufweist, in welcher der Tiegel (102) angeordnet ist.

**10.** Verfahren zur Erstarrung eines Halbleiters nach einem der vorhergehenden Ansprüche, bei dem, wenn die eine oder mehreren zusätzlichen Chargen eines Halbleiters (120) dem Halbleiterbad (103) in fester Form zugesetzt werden, dieses ein- oder mehrmalige Zusetzen mittels einer Verteilungsvorrichtung (110) realisiert wird, die auch ein Vorheizen der einen oder mehreren zusätzlichen Chargen eines Halbleiters (120) realisiert.

**11.** Verfahren zur Erstarrung eines Halbleiters nach Anspruch 7, bei dem die Zeitpunkte, bei denen das ein oder mehrmalige Zusetzen der einen oder mehreren zusätzlichen Chargen eines Halbleiters (120) realisiert werden, durch Steuereinrichtungen der Verteilungsvorrichtung (110) bestimmt werden.

**12.** Verfahren zur Erstarrung eines Halbleiters nach einem der vorhergehenden Ansprüche, bei dem die Konzentration mindestens eines Dotierstoff-Typs in der ersten Charge eines Halbleiters unterschiedlich zur Konzentration des gleichen Dotierstoff Typs in der oder den zusätzlichen Chargen des Halbleiters (120) ist.

**13.** Verfahren zur Erstarrung eines Halbleiters nach einem der vorhergehenden Ansprüche, bei dem der geschmolzene Halbleiter in Form eines Barrens oder Bandes erstarrt.

FIG. 1

FIG. 2

FIG. 3

FIG. 4

**EP 2 208 810 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2007001184 A1
- US 2008220544 A1